# EUROPÄISCHE PATENTSCHRIFT

(11) **EP 1 544 163 B1**
(45) Veröffentlichungstag und Bekanntmachung des Hinweises auf die Patenterteilung: **24.02.2021**
(21) Anmeldenummer: 04105448.7
(22) Anmeldetag: 02.11.2004
(51) Int. Cl.: B81B 3/00, B81C 1/00

(54) **Verfahren zur Herstellung eines Membransensors und entsprechender Membransensor**
Method for producing a membrane sensor and corresponding membrane sensor
Méthode de production d'un capteur à membrane et capteur à membrane correspondant

(30) Priorität: 16.12.2003 DE 10358859; 24.07.2004 DE 10436032
(43) Veröffentlichungstag der Anmeldung: 22.06.2005
(60) Teilanmeldung: 08104525.4
(73) Patentinhaber: Robert Bosch GmbH, 70442 Stuttgart (DE)
(72) Erfinder: BENZEL, Hubert, 72124 Pliezhausen (DE); SCHAEFER, Frank, 72070 Tuebingen (DE); ARMBRUSTER, Simon, 72762 Reutlingen (DE); LAMMEL, Gerhard, 72070 Tuebingen (DE); SCHELLING, Christoph, 72762 Reutlingen (DE); BRASAS, Joerg, 72141 Walddorfhaeslach (DE)

(56) Entgegenhaltungen:
- DE-A1- 10 032 579
- STEINER P ET AL: "MIKROSTRUKTURIERUNG MIT POROESEM SILIZIUM" ITG-FACHBERICHTE, VDE VERLAG, BERLIN, DE, Bd. 126, März 1994 (1994-03), Seiten 285-290, XP002900484 ISSN: 0932-6022

## Beschreibung

### Stand der Technik

Die Erfindung betrifft ein Verfahren zur Herstellung eines Halbleiterbauelements nach dem Oberbegriff des Patentanspruchs 1 sowie ein Halbleiterbauelement, welches mit einem derartigen Verfahren hergestellt wurde.

Halbleiterbauelemente, insbesondere Membransensoren sowie Verfahren zur Herstellung von Membransensoren auf der Basis von Halbleiterträgern, zum Beispiel von Siliziumwafern sind bereits bekannt. Dabei werden beispielsweise auf den Halbleiterträger flächige poröse Membranbereiche als Trägerschicht für Sensorstrukturen angeordnet und unter der Membran eine Kavität zur insbesonderen thermischen Isolation der Membran erzeugt.

Die zur Zeit auf dem Markt befindlichen Membransensoren sind zumeist als Dünnschichtmembransensoren realisiert. Hierzu werden Schichtsysteme in Dicken zwischen einigen 10 nm und einigen µm auf einem Trägersubstrat abgeschieden und danach das Trägersubstrat in vorgegebenen Bereichen entfernt, um freitragende Membranbereiche zu erhalten. Im Membranzentrum können dann Sensorstrukturelemente angeordnet werden.

Eine weitere Möglichkeit zur Freilegung der Membran ist die Oberflächenmikromechanik (OMM), bei welcher im allgemeinen eine Opferschicht verwendet wird, die vor der Membranabscheidung auf der Vorderseite eines Trägersubstrats aufgebracht wird. Die Opferschicht wird später von der Vorderseite des Sensors durch "Löseöffnungen" in der Membran entfernt, wodurch eine freitragende Struktur entsteht. Diese oberflächenmikromechanischen Verfahren sind aufgrund der Notwendigkeit von separaten Opferschichten vergleichsweise aufwändig.

Aus der deutschen Patentanmeldung DE 100 32 579 A1 ist ein Verfahren zur Herstellung eines Halbleiterbauelements sowie eines nach dem Verfahren hergestellten Halbleiterbauelements bekannt, bei welchem für insbesondere einen Membransensor eine Schicht aus porösiziertem Halbleiterträgermaterial über einer Kavität angeordnet ist. Zur Herstellung der Kavität werden dabei mittels entsprechender Ätzparameter zwei Schichten unterschiedlicher Porosität hergestellt. Während die erste Schicht eine geringere Porosität aufweist und sich bei einem folgenden ersten Temperschritt schließt, nimmt die Porosität der zweiten Schicht während des Temperschritts derart zu, dass eine Kavität bzw. Kaverne gebildet wird. Auf der sich so aus der ersten porösen Schicht gebildeten ersten Membranschicht wird in einem zweiten Prozessschritt bei einer höheren Tempertemperatur eine verhältnismäßig dicke Epitaxieschicht als zweite Membranschicht aufgewachsen.

In Erweiterung der DE 100 32 579 A1 kann auch vorgesehen sein, während des ersten Temperschritts eine dünne Epitaxieschicht aufzuwachsen, um sicherzustellen, dass sich die poröse erste Schicht, die als Startschicht für das Epitaxiewachstum der dicken Epitaxieschicht dient, vollständig schließt. Bevorzugt wird dabei eine geringere Wachstumsrate bei einer niedrigeren Temperatur im Vergleich zu der anschließenden Abscheidung der dicken Epitaxieschicht gewählt.

Durch die so geschilderten Maßnahmen kann der Aufbau eines OMM-Halbleiterbauelements erheblich vereinfacht werden, da eine zusätzlich aufgebrachte Opferschicht nicht erforderlich ist und zudem die Membran selbst bzw. ein wesentlicher Teil der Membran aus Halbleiterträgermaterial erzeugt wird.

Es hat sich jedoch in Versuchen herausgestellt, dass eine wenigstens teilweise poröse Membran bereits während der Herstellung Schaden nehmen kann bzw. sich auch im Anwendungsfall eine Beschädigung unter herkömmlichen Einsatzbedingungen nicht immer sicher vermeiden lässt. Zur Vermeidung einer Membranschädigung bei der Herstellung oder bei regelmäßig auftretenden Anwendungsfällen wird in der DE 101 38 759 A1 ein Verfahren zur Herstellung eines Halbleiterbauelements mit einem Halbleiterträger vorgeschlagen, bei dem der Halbleiterträger im Bereich der porösen Membranschicht eine zum Bereich der späteren Kavität unterschiedliche Dotierung erhält. Nach der Dotierung wird das Halbleitermaterial der Membranschicht porösiziert und das Halbleitermaterial unter dem porösizierten Halbleitermaterial zur Bereitstellung einer Kavität wenigstens teilweise entfernt bzw. umgelagert.

Aus der DE 100 30 352 A1 ist ein mikromechanisches Bauelement bekannt, welches einen Tragkörper aus Silizium und eine bereichsweise freitragende, mit dem Tragkörper verbundene Membran aufweist. Zur Stützung ist die Membran bereichsweise oberflächlich mit wenigstens einem Stabilisierungselement versehen. Zur Bildung der bereichsweise freitragenden Membran ist vorgesehen, das Silizium in einem ersten Bereich zu porösizieren und nach Abscheidung der Membranschicht selektiv durch eine Ätzöffnung zu entfernen.

### Vorteile der Erfindung

Die Erfindung beschreibt ein Herstellungsverfahren eines insbesondere mikromechanischen Drucksensors. Zur Herstellung des Halbleiterbauelements ist vorgesehen, dass auf einem Halbleiterträger ein strukturiertes Stabilisierungselement mit wenigstens zwei Öffnungen erzeugt wird. Die Öffnungen sind dabei so angebracht, dass sie den Zugang zu einem mit einer ersten Dotierung aufweisenden ersten Bereich im Halbleiterträger erlauben. Weiterhin ist ein selektives Herauslösen wenigstens eines Teils des mit der ersten Dotierung versehenen Halbleitermaterials aus dem ersten Bereich des Halbleiterträger vorgesehen. Darüber hinaus wird mittels einer ersten Epitaxieschicht, die auf das Stabilisierungselement aufgebracht wird, eine Membran oberhalb des ersten Bereichs erzeugt. Wenigstens ein Teil des ersten Bereichs dient in einem weiteren Verfahrensschritt dazu, eine Kaverne unterhalb des Stabilisierungselement zu erzeugen. Das strukturierte Stabilisierungselement wird mittels einer strukturierten zweiten Epitaxieschicht erzeugt, die auf dem Halbleiterträger aufgebracht wird.

Durch ein Aufwachsen der ersten Epitaxieschicht auf das Stabilisierungselement kann vorteilhafterweise die Membran stabiler hergestellt werden, da zum einen das Stabilisierungselement die erste Epitaxieschicht stützt und zum anderen ein einheitliches Aufwachsen der ersten Epitaxieschicht auf dem Stabilisierungselement ohne Kristallfehler möglich ist.

Gemäß der Erfindung ist vorgesehen, dass die Epitaxiebedingungen derart gewählt werden, dass die erste Epitaxieschicht ausgehend von wenigstens einem Teil des Stabilisierungselements die wenigstens zwei Öffnungen über dem ersten Bereich in lateraler und/oder vertikaler Richtung verschließt. Vorteilhafterweise werden die Epitaxiebedingungen derart gewählt, dass das epitaktische Wachstum lediglich auf dem Stabilisierungselement und nicht auf dem ersten Bereich erfolgt. Dies kann unter anderen auch dadurch erreicht werden, dass der erste Bereich gesondert passiviert wird. Im Rahmen dieses Epitaxievorgangs kann vorgesehen sein, dass das Stabilisierungselement weitestgehend abgedeckt wird.

Die Kaverne des Halbleiterbauelements kann in einem weiteren Verfahrensschritt durch einen thermisch induzierten Umlagerungsvorgang des Halbleitermaterials des ersten Bereichs erzeugt werden. Dabei kann insbesondere vorgesehen sein, dass diese Umlagerung nach dem epitaktischen Aufwachsen der ersten Epitaxieschicht und somit nach Erzeugung der Membran durchgeführt wird.

Gemäß der Erfindung ist vorgesehen, dass das Stabilisierungselement aus der zweiten Epitaxieschicht gebildet wird. Dabei wird die zweite Epitaxieschicht derart mit Öffnungen versehen, dass durch diese Öffnungen das dotierte Halbleitermaterial des ersten Bereichs herausgelöst werden kann. Eine Möglichkeit, diese Öffnungen herzustellen besteht darin, die zweite Epitaxieschicht wenigstens stellenweise durch eine Lichtquelle zu belichten und die so belichteten Stellen der zweiten Epitaxieschicht herauszulösen. Dabei kann insbesondere vorgesehen sein, dass das Entfernen des belichteten Materials der zweiten Epitaxieschicht und das selektive Herauslösen des mit den ersten Dotierungen versehenen Halbleitermaterials aus dem ersten Bereich im gleichen Verfahrensschritt erfolgt.

Neben dieser Ausgestaltung der Erfindung kann jedoch auch vorgesehen sein, dass die beleuchteten Stellen auf dem Halbleiterträger bzw. auf der zweiten Epitaxieschicht, während eines Ätzvorgangs gerade nicht angegriffen werden. Somit würden die beleuchteten Bereiche als Stege beispielsweise über einem porös geätzten ersten Bereich stehen bleiben.

Die auf die Oberfläche des Halbleiterträgers aufgebrachte zweite Epitaxieschicht kann beispielsweise durch eine zusätzlich aufgebrachte Passivierungsschicht lokal strukturiert werden. Dabei kann vorgesehen sein, dass die so strukturierte zweite Epitaxieschicht über dem ersten Bereich einen zusammenhängenden zweiten Bereich bildet. Dieser zweite Bereich kann beispielsweise in Form eines Gitters und/oder von miteinander verbundenen Stegen ausgebildet sein.

In einer Weiterbildung der Erfindung wird auf den Halbleiterträger eine SiC-Schicht epitaktisch aufgebracht und anschließend strukturiert. Wird diese strukturierte SiC-Schicht nicht weiterbehandelt, so kann in einem weiteren Epitaxieschritt die erste Epitaxieschicht polykristallin auf der SiC-Schicht aufwachsen. Dagegen kann bei einer thermischen Behandlung der strukturierten SiC-Schicht erreicht werden, dass die zweite Epitaxieschicht monokristallin aufwächst.

Gemäß der Erfindung weist das Stabilisierungselement wenigstens einen Steg und/oder ein Gitter oberhalb der Kaverne auf. Optional kann das Stabilisierungselement auch eine Einfassung am Rand der Kaverne aufweisen. Bei der Gestaltung des Stabilisierungselements oberhalb der Kaverne kann vorgesehen sein, dass die Dicke des Stabilisierungselements variiert. Darüber hinaus kann vorgesehen sein, dass die Einfassung im Vergleich zu dem Gitter und/oder zu dem wenigstens einen Steg eine größere Dicke aufweist.

Besonders vorteilhaft ist durch das Herstellungsverfahren die Einstellung der Steifigkeit der Membran über die Positionierung der Öffnungen auf dem Stabilisierungselement und/oder die Gestaltung der Stege durch die Variation verschiedener Herstellungsparameter. Als Herstellungsparameter können dabei die Parameter während des epitaktischen Wachstums, die geometrische Anordnung der Öffnungen und/oder die lateralen bzw. vertikalen Ausdehnungen der Stege angesehen werden. So sind Stege mit dreieckigem Querschnitt bzw. mit unterschiedlichen vertikalen und/oder lateralen Ausdehnungen herstellbar.

Das Gitter bzw. der wenigstens eine Steg im Oberflächenbereich des Halbleiterträgers kann durch eine Kombination wenigstens zweier Implantationsschritte erreicht werden. Dabei kann in einem zweiten Bereich des Halbleiterträgers eine von den ersten Dotierungen des ersten Bereichs unterscheidbare zweite Dotierung erzeugt werden. Dieser zweite Bereich kann dann in einem späteren Verfahrensschritt zum Stabilisierungselement bzw. zum Gitter und/oder zu einem Steg weitergebildet werden. Dies kann beispielsweise dadurch geschehen, dass während der nachfolgenden selektiven Herauslösung lediglich das Halbleitermaterial aus dem ersten Bereich herausgelöst wird, das Material des zweiten Bereichs jedoch auf bzw. im Halbleiterträger verbleibt.

In einer Weiterbildung der Erfindung ist vorgesehen, dass über dem ersten Bereich im Halbleiterträger, die eine ersten Dotierung aufweist, ein dritter Bereich erzeugt wird, der ebenfalls die erste Dotierung aufweist. Dabei ist vorgesehen, dass die Dotierung des dritten Bereichs eine im Vergleich zur Dotierung des ersten Bereichs höhere Dotierungskonzentration aufweist. Weiterhin ist vorgesehen, dass oberhalb des ersten und des dritten Bereichs die zweite Epitaxieschicht mit einer von der ersten Dotierung unterscheidbaren zweiten Dotierung erzeugt wird. Durch eine Strukturierung der zweiten Epitaxieschicht kann in einem weiteren Verfahrensschritt erreicht werden, dass ein Zugang durch die Epitaxieschicht auf den dritten und schließlich auf den ersten Bereich ermöglicht wird. Vorteilhafterweise wird anschließend ein Ätzverfahren zum Herauslösen des Halbleitermaterials verwendet, welches selektiv lediglich das Halbleitermaterial mit der ersten Dotierung herauslöst, das Material mit der zweiten Dotierung jedoch nicht angreift. Durch die Wahl der höheren Dotierungskonzentration in Verbindung mit einem entsprechenden Ätzverfahren kann erreicht werden, dass aus dem dritten Bereich mehr Halbleitermaterial herausgelöst wird als aus dem ersten Bereich. Durch ein derartiges Verfahren kann bei dem so hergestellten Stabilisierungselement eine nahezu plane Unterseite erzeugt werden.

In einer anderen Ausführung der Erfindung wird die Oberfläche des Halbleiterträgers über wenigstens einem Teil des ersten Bereichs mit der ersten Dotierung strukturiert. Anschließend wird eine zweite Epitaxieschicht mit einer zweiten Dotierung auf der Oberfläche des strukturierten Halbleiterträgers erzeugt und ebenfalls strukturiert. Dabei ist vorgesehen, dass die strukturierte zweite Epitaxieschicht das Stabilisierungselement bildet. Im Folgenden wird das Halbleitermaterial aus dem ersten Bereich selektiv herausgelöst und auf den so strukturierten ersten und zweiten Bereich die erste Epitaxieschicht abgeschieden.

Vorteilhafterweise ist vorgesehen, dass die erste und die zweite Dotierung unterschiedliche Dotierungen aufweisen. So kann vorgesehen sein, dass der erste Bereich eine p-Dotierung und der zweite Bereich, die Einfassung bzw. das Gitter und/oder der wenigstens eine Steg, eine n-Dotierung aufweist.

Gemäß der Erfindung sind sowohl die erste Epitaxieschicht, als auch das Stabilisierungselement, bspw. das Gitter oder der wenigstens eine Steg monokristallin ausgebildet.

Weitere Vorteile ergeben sich aus der nachfolgenden Beschreibung von Ausführungsbeispielen bzw. aus den abhängigen Patentansprüchen.

### Zeichnungen

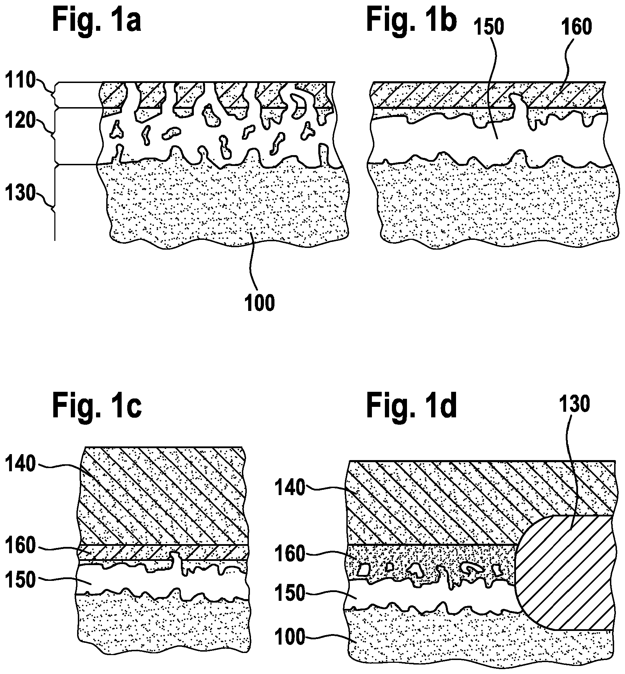

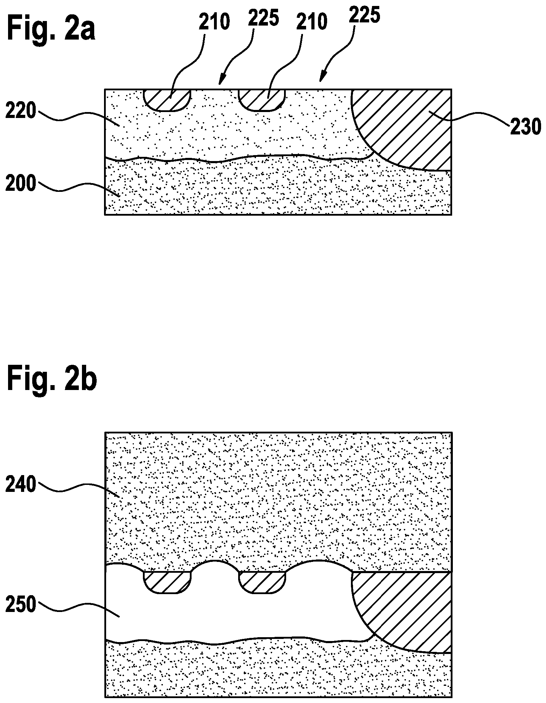

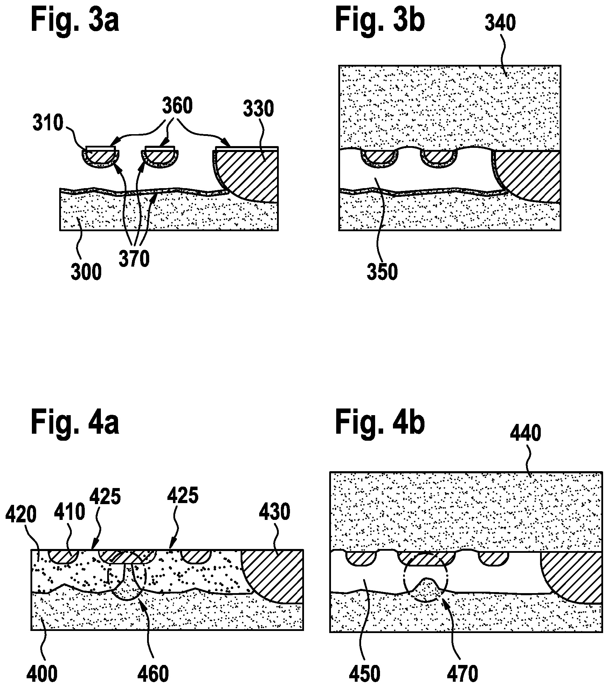

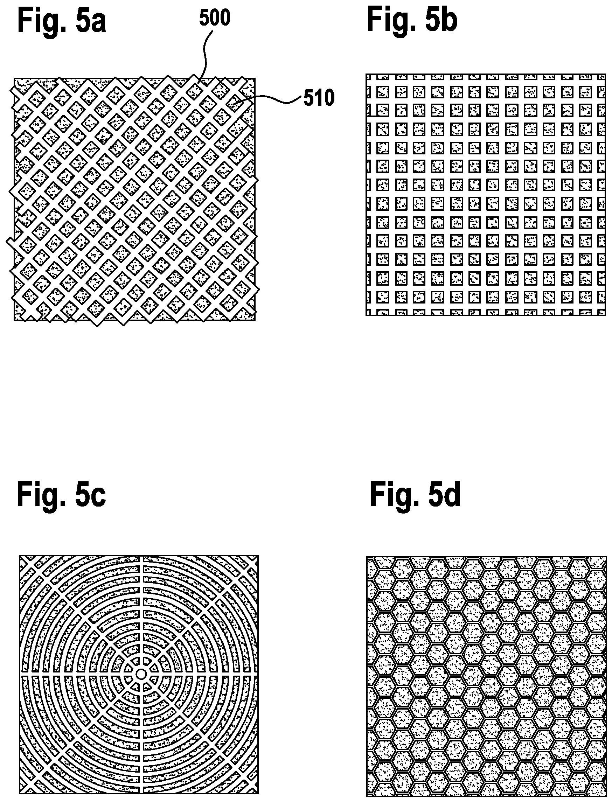

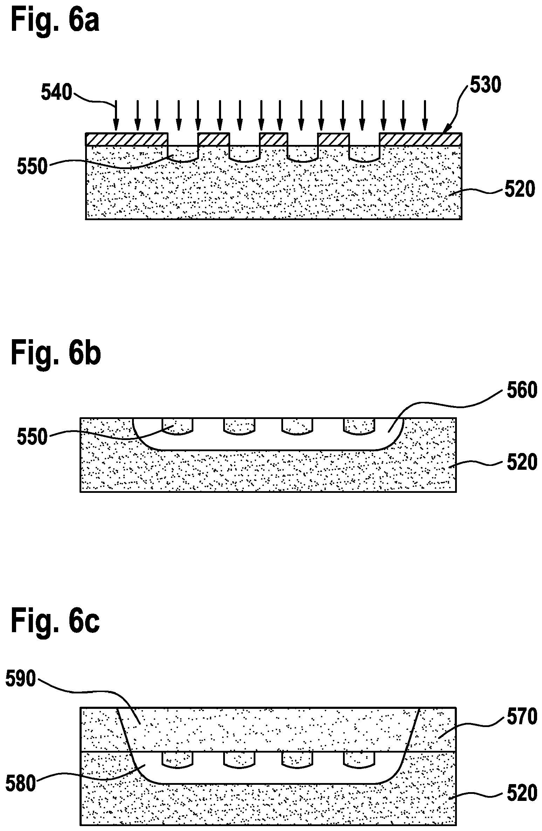

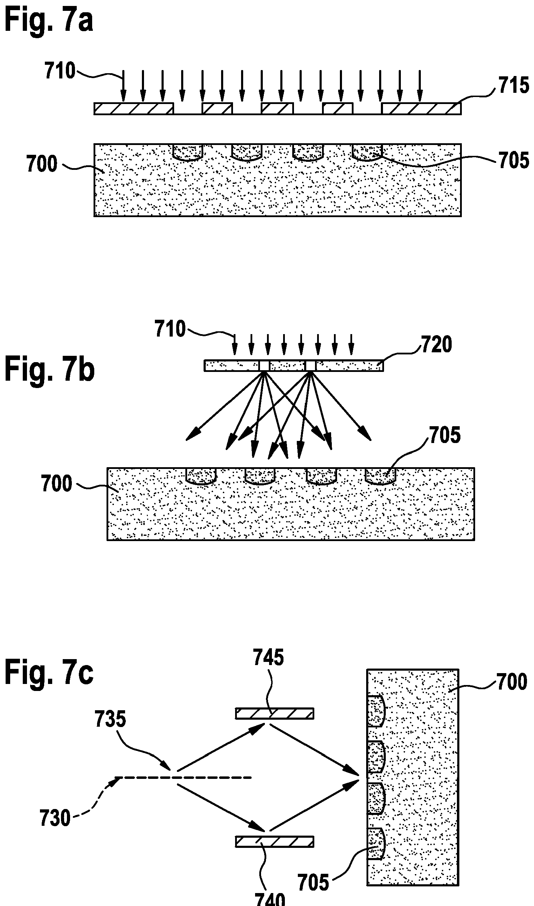

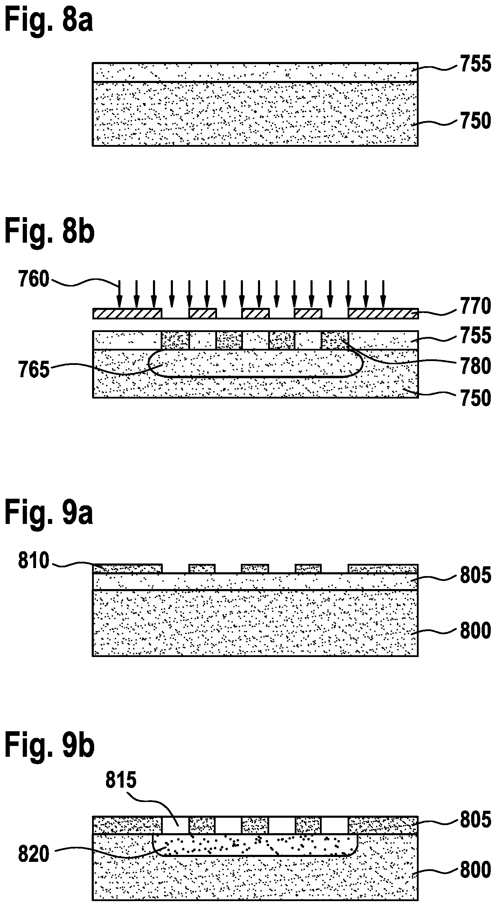

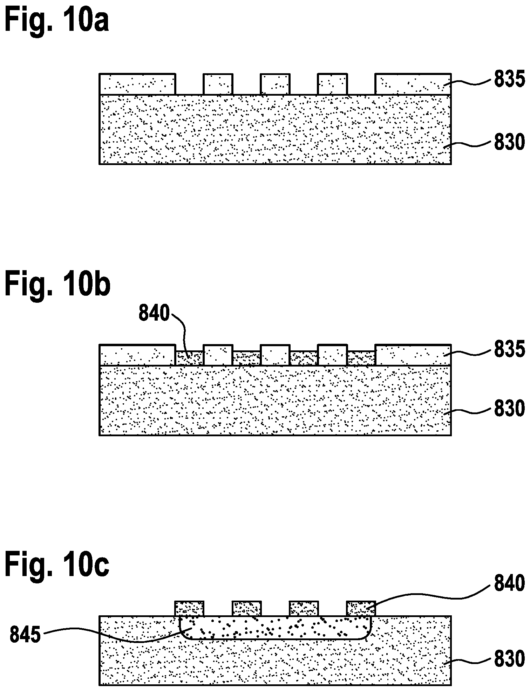

In der Figur 1 wird ein Verfahren zur Herstellung einer mikromechanischen Membran gezeigt, wie er aus dem Stand der Technik bekannt ist. Figur 2 zeigt eine weitere nicht beanspruchte Herstellung. Eine spezielle Behandlung der Oberfläche zur Verhinderung der Ablagerung von Epitaxiematerial wird in der nicht beanspruchten Figur 3 gezeigt. In Figur 4 wird ein Beispiel gezeigt, welches die Bildung der Stege mittels eines nicht erfindungsgemäßen Verfahrens darstellt. Die Figuren 5a bis d zeigen verschiedene mögliche Ausgestaltungen der Stege, auf denen die Membran abgeschieden wird. Die Figuren 6 und 7 zeigen weitere nicht erfindungsgemäße Verfahren. Mit den Figuren 8 und 9 sowie 15 und 17 wird das erfindungsgemäße Verfahren dargestellt. In den Figuren 10 bis 14 sowie 16 sind weitere, nicht beanspruchte Beispiele zur Erzeugung von Stegen bzw. Gittern über einer Kaverne dargestellt.

### Ausführungsbeispiel

Wie eingangs bereits geschildert, sind aus dem Stand der Technik verschiedene mikromechanische Verfahren zur Herstellung einer Membran bekannt. So kann beispielsweise mit Hilfe einer porösen Doppelschicht in einem Halbleiterträger 100, wie sie in Figur 1a anhand einer niedrigporösen Schicht 110 und einer darunter liegenden hochporösen Schicht 120 dargestellt ist, eine für das Wachstum der Epitaxieschicht 140 geeignete Startschicht 160 sowie eine Kaverne 150 gebildet werden (siehe Figur 1b). Die Umbildung findet dabei durch einen ersten Temperschritt (bei ca. 900 bis 1000° C) statt, bei dem sich die Halbleiteratome der niedrigporösen Schicht 110 derart verlagern, dass sich im Idealfall die Oberfläche schließt. Im gleichen oder in einem folgenden Temperschritt kann dann die Kaverne 150 ebenfalls durch Umlagerung der Halbleiteratome aus der hochporösen Schicht 120 gebildet werden. Dies geschieht dadurch, dass sich unter dem Einfluss des Temperschritts die Poren vergrößern und schlussendlich zu einer "Riesenpore" vereinigen, die dann die Kaverne darstellt. Zur Herstellung der Membran kann nun auf die Startschicht 160 eine Epitaxieschicht 140 aufgebracht werden, die die Eigenschaften der Membran bestimmen. In der Realität gibt es bei der Herstellung einer solchen Membran aber immer wieder Poren, die sich nicht verschlossen haben, da das Angebot an Silizium nicht ausreicht. Teilweise lagern sich auch mehrere kleine Poren zu einer großen Pore zusammen, so dass Poren mit Durchmessern von bis zu 0,5 µm entstehen. Auf diesen unverschlossenen Stellen in der Startschicht kann die Epitaxieschicht, die die spätere Membran bildet, nicht monokristallin aufwachsen, da die Kristallstruktur der Unterlage fehlerhaft ist. Es bilden sich daher Kristallfehler in der Epitaxieschicht aus (z.B. durch Stapelfehler). Auf der Oberseite der Membran werden im weiteren Prozessablauf beispielsweise piezoresistive Widerstände erzeugt, die für die Funktion eines Drucksensors benötigt werden. Diese Widerstände können durch Kristallfehler in der Epitaxieschicht während der Lebensdauer des Sensors degradieren und zu einer Drift des Sensorsignals führen.

Abhilfe kann bei der Erzeugung einer monokristallinen Epitaxieschicht das Aufbringen einer ersten dünnen Epitaxieschicht (dünner als 1 µm, bevorzugt 200-600 nm) bringen, bei der sofort zu Beginn, während oder am Ende der ersten Temperung zusätzliches Halbleitermaterial angeboten wird, um die Startschicht vollständig zu schließen. Vorzugsweise wird dabei das gleiche Halbleitermaterial aufgebracht, welches bereits in der Schicht 110 vorhanden ist und/oder in der Epitaxieschicht 140 verwendet wird. Besteht der Halbleiterträger 100 beispielsweise aus Silizium, so wird mit einem derartigen Verfahren den angebotenen Silizium-Atomen ausreichend Zeit gelassen, sich entsprechend dem Siliziumkristall der Unterlage anzuordnen. Vorteilhafterweise wird bei dem Aufwachsen der dünnen Epitaxieschicht eine geringere Temperatur und eine geringere Wachstumsgeschwindigkeit im Vergleich zu der späteren dicken Epitaxieschicht gewählt. So beträgt beispielsweise die Temperatur bei dem Aufbringen der dünnen Epitaxieschicht in einem besonderen Ausführungsbeispiel ca. 900 bis 1000°C, wohingegen die Wachstumsgeschwindigkeit kleiner als 0,5 µm/min gewählt wird.

Nach dem Aufwachsen dieser dünnen Epitaxieschicht und einer eventuellen Fortführung der Temperung wird das Substrat einer höheren Temperatur ausgesetzt (bevorzugt 1100 bis 1200° C), um dann dort eine zweite, dicke Epitaxieschicht 140 (einige µm) aufzuwachsen. Vor dem Wachstum der zweiten Epitaxieschicht kann auch noch bei der höheren Temperatur eine weitere Temperung erfolgen, um mögliche Kristallfehler in der verschlossenen Startschicht auszuheilen. Die zweite Epitaxieschicht bildet auf Grund ihrer relativ großen Dicke - im Vergleich zur Start- und ersten Epitaxieschicht - die eigentliche Membran. Diese kann dann beispielsweise für einen Drucksensor oder nach einer weiteren Strukturierung auch für einen Beschleunigungssensor genutzt werden.

Wird eine einkristalline, mikromechanische Membran auf eine poröse Startschicht aufgebracht, so bestehen verschiedene Schwachpunkte, die die Erzeugung bzw. die Lebensdauer der Membran nachteilig beeinflussen können. So kann beispielsweise die poröse Startschicht Risse bekommen, die sich auf der darauf abgeschiedenen Epitaxieschicht fortpflanzen. Weiterhin können Übergänge von der beispielsweise p+-dotierten Startschicht 160 zu einer Einrahmung 170 der Startschicht auftreten. Dabei wird beim Überlapp beider Dotierungen die p+-Dotierung auf eine p-Dotierung reduziert (Figur 1d). Eine geringere p-Dotierung bewirkt aber auch eine höhere Porosität. Dieser Effekt wird auch bei der Erzeugung der Doppelschicht nach Figur 1a verwendet, bei der die niedrigporöse Schicht 110 beispielsweise eine p+-Dotierung und die hochporöse Schicht 120 eine geringere p-Dotierung aufweist. Somit ist die niedrigporöse Schicht über einen hochporösen und damit fragilen Bereich mit dem Rand verbunden. Hier können unter anderem während der Herstellung Risse auftreten.

Eine mögliche Herstellung einer monokristallinen Membran wird außerdem anhand der Figuren 2a und b beschrieben. Hierzu wird auf einem Halbleiterträger 200 ein erster Bereich 220 und ein zweiter Bereich 210 mit unterschiedlichen Dotierungen erzeugt, wobei der erste Bereich 220 auch aus der Substratdotierung bestehen kann. Im folgenden Ausführungsbeispiel soll davon ausgegangen werden, dass der Halbleiterträger 200 eine p-Dotierung, der erste Bereich 220 eine p- bzw. p+-Dotierung und der zweite Bereich 210 bzw. 230 eine n- bzw. n+-Dotierung aufweist. Hierbei kann der Teil des zweiten Bereichs, der in Figur 2a mit 210 bezeichnet ist, als eine Art Steg oder Gitter auf der Oberfläche des Halbleiterträgers ausgebildet werden, wohingegen der Teil des zweiten Bereichs, der in Figur 2a als 230 bezeichnet wird, als Einrahmung des ersten Bereichs 220 ausgebildet ist. Weiterhin kann vorgesehen sein, dass die Einrahmung 230 und der Teil 210 des ersten Bereichs unterschiedliche Dotierungen, z.B. n⁺ bzw. n⁰ aufweisen kann.

Durch einen entsprechenden Ätzprozess, beispielsweise durch eine Anodisierung bzw. Elektropolitur wird der erste Bereich 220 porös geätzt. Dabei kann es sich wie bereits beschrieben, bei dem ersten Bereich 220 sowohl um einen Teil des unbehandelten Halbleiterträgers 200 als auch um einen zusätzlich dotierten Bereich handeln. Letzteres hat den Vorteil, dass eine schärfere Abgrenzung bei der Erzeugung des porösen Bereichs 220 möglich ist. Während der erste Bereich 220 beispielsweise bis in eine Tiefe von 5 bis 20 µm ausgehend von der Oberfläche des Halbleiterträgers 200 porös geätzt wird, wird der zweite Bereich 210 durch den Ätzprozess im Wesentlichen nicht verändert. Bei einer entsprechenden Wahl der lateralen Ausdehnung der zweiten Bereiche 210 auf der Oberfläche des Halbleiterträgers 200 kann auch unterhalb der zweiten Bereiche 210 der erste Bereich 220 poröses geätzt werden. Zur weiteren Bearbeitung ist in einem besonderen Ausführungsbeispiel vorgesehen, dass der erste Bereich 220 eine hohe Porösität aufweist. Denkbar sind hierbei Porengrößen von 1 nm bis einigen µm Durchmesser. Alternativ kann eine hohe Porösität dadurch erreicht werden, dass sehr viele kleine Poren (∼ 5 nm) oder wenige sehr große Poren (einige bis mehrere 100 nm) erzeugt werden. Das Resultat ist ebenso wie bei der Erzeugung von großen Poren derart, dass viel Silizium herausgeätzt wird. Besteht der Halbleiterträger 200 aus Silizium, so ist auf der Oberfläche des unbehandelten Halbleiterträgers eine (natürliche) Oxidschicht zu finden. In einem folgenden Prozessschritt wird deshalb eine Reduktion der (natürlichen) Oxidschicht auf der Siliziumoberfläche dadurch erreicht, dass eine kurze Temperung des Halbleiterträgers bzw. des Siliziumsträgers unter einer Wasserstoffatmosphäre durchgeführt wird. Alternativ kann hier ein "HF-Last"-Verfahren oder ein HF-GPÄ-Verfahren mit anschließender Niedertemperaturepitaxie eingesetzt werden, um den gleichen Effekt zu erreichen. Anschließend wird der Halbleiterträger auf Wachstumstemperatur (1000 bis 1200° C) aufgeheizt, bevor mit dem Auftrag einer monokristallinen Epitaxieschicht 240 begonnen wird. Die Epitaxieschicht wächst hauptsächlich auf den zweiten Bereichen 210 und 230 auf. In einem besonderen Ausführungsbeispiel sind die Bereiche 210 als monokristalline Stege ausgebildet, um ein Aufwachsen des Epitaxiematerials zu fördern. Das Wachstum erfolgt dabei nicht nur vertikal d.h. senkrecht zur Oberfläche, sondern auch lateral, so dass die Bereiche zwischen den einzelnen Stegen 210 durch eine monokristalline Schicht verschlossen werden. Figur 2b zeigt die Membran nach dem Aufwachsen der Epitaxieschicht 240. Das hochporöse Silizium hat sich während des Aufwachsvorgangs unter dem Einfluss der Wachstumstemperatur oder während eines weiteren Tempervorgangs zu einer großen Kaverne 250 umgelagert. Auf der Membranunterseite der Figur 2b sieht man die Form, die sich durch das Zuwachsen der freien Bereiche zwischen den Stegen ergibt. Durch weiteres Tempern kann diese Form flach verschmelzen.

Das hochporöse Silizium zwischen den monokristallinen Stegen 210 ist hier vorteilhaft, da dadurch verhindert wird, dass das Silizium innerhalb des Kavernenbereichs aufwächst. Wäre die Kaverne völlig frei, dann könnte - abhängig von den Wachstumsbedingungen - vom Start des Epitaxiewachstums an, auf den Kavernenwänden Silizium aufwachsen. Durch die anfängliche poröse Oberfläche zwischen den Stegen 210, die sich im Laufe des Epitaxievorgangs umlagert, wird jedoch verhindert, dass Silizium zwischen den Stegen 210 aufwächst bzw. ein nennenswerter Eintrag des Epitaxiematerials in die Kaverne 250 erfolgt.

Selbstverständlich kann die beschriebene Erzeugung einer Epitaxieschicht mit darunter liegender Kaverne mittels einer Porösizierung auch bei der Verwendung anderer Materialien bzw. Halbleitermaterialien durchgeführt werden und ist nicht auf die Verwendung von Silizium begrenzt. Voraussetzung dabei ist jedoch, dass diese anderen Materialien bzw. Halbleitermaterialien ebenfalls porösiziert werden können.

In einem weiteren nicht beanspruchten Beispiel wird der Bereich zwischen und unterhalb der Stege nicht porös geätzt, sondern komplett herausgelöst. Dies kann beispielsweise durch eine Elektropolitur erfolgen, d. h. die Porösität wird durch Variation der Ätzparameter (z.B. Erhöhung des Stroms, Reduktion der HF-Konzentration) so stark erhöht, dass sie 100 Prozent erreicht. Nun können die Stege wie oben beschrieben, zugewachsen werden, wobei die Gefahr besteht, dass innerhalb der Kaverne ebenfalls Silizium aufwächst. Um das zu verhindern kann die Innenseite der Kaverne mit einer Schicht geschützt werden, die das Aufwachsen von Silizium verhindert.

Ein derartiger Schutz könnte beispielsweise durch das Aufbringen einer Siliziumnitridschicht (SiN) 360 auf die Oberfläche der zweiten Bereiche 310 gemäß der Figur 3a erreicht werden, welches jedoch nicht Gegenstand der beanspruchten Erfindung ist. Anschließend können durch eine Elektropolitur die als Stege ausgebildeten zweiten Bereiche 310, die untereinander und mit der Einrahmung 330 verbunden sind, durch das Entfernen des ersten Bereichs freigestellt werden (siehe Querschnitt durch den Halbleiterträger in Figur 3a). Auf den freiliegenden Bereichen der zukünftigen Kaverne 350 wird beispielsweise durch thermische Oxidation ein Oxid 370 erzeugt. Anschließend kann z. B. durch heiße Phosphorsäure das Nitrid 360 selektiv zum Oxid 370 abgelöst werden. Durch diese Vorbereitung kann eine selektive Epitaxie erreicht werden, d. h. das Epitaxiematerial (z.B. Silizium) wächst nur auf den Bereichen auf, die nicht durch Oxid 370 geschützt sind. Dadurch wird verhindert, dass in der Kaverne 350 Silizium aufwächst.

Eine weitere Möglichkeit das Aufwachsen von Silizium selektiv zu verhindern besteht darin, vor dem Aufbringen der Siliziumnitridschicht (SiN) 360 eine dünne (< 60 nm) Siliziumoxidschicht (SiO) auf die Bereiche aufzubringen, die nicht elektropoliert werden sollen. Nach der Freistellung der Stege 310 durch einen entsprechenden Ätzprozess, z.B. durch eine Elektropolitur, kann ebenfalls wie in dem bereits geschilderten Beispiel auf den freiliegenden Bereichen durch thermische Oxidation ein Oxid erzeugt werden. Dabei ist jedoch zu beachten, dass dieses Oxid dicker als das Oxid unter der SiN-Maske sein muss. Anschließend kann das Nitrid selektiv zum Oxid abgelöst werden. Alternativ kann auch ein Trockenätzprozess durchgeführt werden, bei dem das Oxid und das Nitrid gleiche Ätzraten aufweist. Durch eine entsprechende Wahl der Ätzzeit kann erreicht werden, dass nach dem Ablösen des Oxids, welches sich unter dem SiN befand, noch eine ausreichend dicke Oxidschicht auf den Kavernenwänden verbleibt. Abschließend kann entsprechend dem vorstehenden Ausführungsbeispiel eine selektive Epitaxie durchgeführt werden.

In einem weiteren Beispiel, bei dem der Halbleiterträger beispielsweise aus Silizium besteht, wird das Silizium zwischen und unter den Stegen porös geätzt. Anschließend wird auf allen Siliziumoberflächen (d. h. Waferoberfläche sowie auf der Oberfläche der Porenwände) eine dünne Schicht Oxid erzeugt, beispielsweise wenige nm dick. Dies kann beispielsweise durch thermische Oxidation, durch Sauerstoffplasmabehandlung, durch chemische Oxidation oder auch auf andere Art und Weise erfolgen. Dieses Oxid verhindert, dass sich das poröse Silizium bei weiteren Hochtemperaturschritten, wie sie bei der Epitaxie oder weiteren Ofenprozessen notwendig sind, umlagert. Durch einen kurzen HF-Dip mit verdünnter Flusssäure (HF) kann nun das Oxid auf der Waferoberfläche entfernt werden. Auf Grund der Oberflächenspannung dringt die Flusssäure nicht in die Poren ein, so dass die Oxidschicht weiterhin auf den Porenwänden verbleibt. Eine entsprechende Beschreibung einer derartigen Vorbehandlung zur Stabilisierung des porösen Siliziums für ein anschließendes Epitaxiewachstum ist beispielsweise in dem Beitrag "Low-pressure vapor-phase epitaxy of silicon on porous silicon", Material Letters (1988) 94 von L. Vescan et al. zu finden. Anschließend kann eine Epitaxieschicht aufgewachsen werden, wobei diese Schicht hauptsächlich auf den monokristallinen Stegen aufwächst. Durch laterales Wachstum wird die Oberfläche verschlossen. Nach der Epitaxie kann ein Zugangsloch beispielsweise von der Vorderseite durch die Epitaxieschicht oder auch von der Rückseite des Halbleiterträgers, geätzt werden und das oxidierte poröse Silizium selektiv durch das Zugangsloch herausgelöst werden. Optional kann das Zugangsloch nach dem Herauslösen auch wieder verschlossen werden, wobei zu beachten ist, dass der Druck, der beim Verschließen des Zugangslochs herrscht, den Referenzdruck in der Kaverne definiert.

Die so hergestellte Membran kann beispielsweise für einen Drucksensor mit piezoresistiven Widerständen verwendet werden. Dazu kann eine Schaltung neben oder auf der Membran integriert werden. Falls ein Zugangsloch von der Rückseite zum selektiven Herauslösen des Halbleitermaterials im zweiten Bereich erzeugt wurde, erhält man einen Rückseiten- bzw. Differenzdrucksensor mit gegenüber dem Stand der Technik genau definierter Membrandicke. Wird ein Zugangsloch von der Vorderseite erzeugt, so muss dieses Loch für die Drucksensor Anwendung wieder druckdicht verschlossen werden.

Allgemein kann in einem weiteren Ausführungsbeispiel optional ein Schritt zum Glätten der Oberfläche durchgeführt werden, falls nach dem Zuwachsen der Löcher die Oberfläche zu rau ist. Eine mögliche Methode mit der das Glätten erreicht werden kann, stellt das chemischmechanisch Polieren (CMP) dar.

In einem weiteren Ausführungsbeispiel ist vorgesehen, die Membran in Form von Schwingerstrukturen zu strukturieren. Mit derartigen Strukturen können beispielsweise Beschleunigungssensoren und/oder Gierratensensoren realisiert werden.

Abseits der vorliegenden Erfindung besteht die Möglichkeit zur Stabilisierung der Stege vor dem Aufwachsen der Epitaxieschicht darin, dass optional Stützen unter den Stegen erzeugt werden, die bei nachfolgenden Hochtemperaturschritten (Epitaxie oder Temperschritte (Oxidation, Diffusion) zur Erzeugung integrierter Schaltungen) durch Umlagerung der Siliziumatome wegschmelzen. Wie in Figur 4a im Bereich 460 zu erkennen ist, entstehen Säulen, wenn die Stege 410 breiter sind als die halbe Ätztiefe im ersten Bereich 420. Dann ist die isotrope Unterätzung bei Anodisierung nicht ausreichend, um das Silizium unter den verbreiterten Stegen 410 zu anodisieren bzw. herauszulösen. Aus energetischen Gründen (Minimierung der Oberflächenenergie) lagert sich Silizium bei hohen Temperaturen (>1000° C) um. Dabei "schmilzt" die Säule (Bereich 470) und die feste Verbindung zwischen Substrat und Membran wird unterbrochen. Somit ist die Membran frei beweglich, wie es die Figur 4b zeigt.

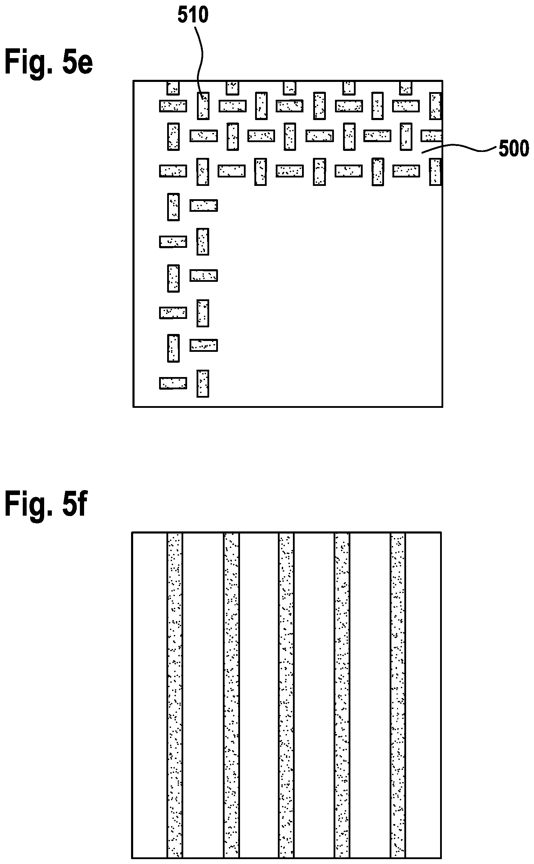

Statt einzelner Stege kann der zweite Bereich oberhalb der Kaverne auch in Form eines Gitters angeordnet sein, wobei sich poröse Bereiche 510 und Stege 500 abwechseln. Beispielhaft hierzu sind in Figur 5a bis f verschiedene mögliche Ausführungsformen dargestellt, wobei die aufgeführten Beispiele nicht als abschließende Darstellung verstanden werden soll. Dabei ist besonders bei den Figuren 5e und 5f eine bessere Lackhaftung zu beobachten.

Zur Realisierung der Stege bzw. des Gitters, auf dem in einem späteren Verfahrensschritt die monokristalline Membran abgeschieden wird, stehen unterschiedliche Verfahren zur Verfügung. So werden in nicht beanspruchten Beispielen gemäß der Figuren 6a bis c die Stege bzw. das Gitter statt durch eine lokale n-Dotierung durch eine lokale Amorphisierung des einkristallinen Si-Substrats erzeugt. Dabei wird, wie in Figur 6a dargestellt, der einkristalline Halbleiterträger aus Silizium 520 mit hochenergetischen Ionen 540, z.B. Argon-Ionen beschossen. Durch diesen Beschuss und die Verwendung einer Implantationsmaske 530 wird die einkristalline Struktur zerstört und es entstehen Bereiche 550 aus amorphem Silizium. Das zurückbleibende amorphe Si 550 wird in der folgenden Anodisierung in Flusssäure nicht angegriffen, so dass unterhalb den amorphen Bereichen 550 ein Bereich 560 aus porösem Si entsteht, welcher sich in einem nachfolgenden Tempervorgang zu einer Kaverne umlagern kann. Somit entsteht ein amorphes Si-Gitter 550, welches vor oder nach diesem nachfolgenden Tempervorgang durch einen Epitaxievorgang überwachsen werden kann. Entsprechend der amorphen Unterlage wird die epitaktische Schicht 590 nicht einkristallin, sondern polykristallin, im Gegensatz zur Schicht 570, die auf dem monokristallinen Bereich 520 aufwächst. Der Übergang zwischen dem polykristallinen Bereich 590 und dem monokristallinen Bereich 570 wird durch die Epitaxieparameter bestimmt.

In einer Varianten dieses Beispiels kann vor dem Wachstum der Epitaxieschicht eine zusätzliche Temperung durchgeführt werden. Durch diese Temperung können die amorphen Stege rekristallisieren und sich zu einem einkristallinen Gitter umlagern. Durch diesen Rekristallisationsschritt ist die Erzeugung einer monokristallinen Si-Epitaxie auf den Gitterstegen möglich.

Auch die Beleuchtungsselektivität des Anodisierungsprozesses kann zur Herstellung des SI-Gitters auf porösem Silizium ausgenützt werden. So kann bei einem Verfahren, wie es anhand der Figuren 7a bis 7c dargestellt ist, ein p-dotiertes Silizium-Substrat 700 während des Anodisierens beleuchtet (710, 735), so dass Bereiche 705 entstehen, die infolge der durch den inneren Fotoeffekt erzeugten Ladungsträger dem Anodisierungsprozess entgegenwirken. Mit Hilfe einer geeigneten Schattenmaske 715, einem Beugungsmuster 720 oder einem holographischen Gitter (Figur 7c) kann ein gitterförmiger Bereich 705 des zu anodisierenden Substrats 700 beleuchtet werden und so vor einer Porosifizierung geschützt werden. Da die Eindringtiefe des Lichts abhängig von der Wellenlänge begrenzt ist, wird der so geschützte Bereich schließlich unterätzt. Der anschließende Epitaxievorgang bzw. die Erzeugung der Kaverne kann dann analog zu dem bereits beschriebenen Verfahren durchgeführt werden.

Zur Erzeugung eines holographischen Gitters kann wie in Figur 7c dargestellt wird, ein Laserstrahl 735 auf einen Strahlteiler 730 geführt werden, wobei die beiden Teilstrahlen an den Spiegeln 740 und 745 reflektiert werden und auf der Substratoberfläche in den Bereiche 705 miteinander wechselwirken.

Als weiteres Beispiel zur Erzeugung eines Si-Gitters kann unter Verwendung der Beleuchtung ähnlich wie im Ausführungsbeispiel zu den Figuren 7a bis c vorgesehen sein, zunächst eine n-dotierte Si-Epitaxieschicht 755 auf einem p-dotierten Si-Substrat 750 zu erzeugen, wie es in Figur 8a dargestellt ist. Anschließend wird gemäß Figur 8b in Anlehnung an das vorherige Beispiel nach Figur 7a bis c die n-dotierte Si-Epitaxieschicht 755 mittels einer geeigneten Beleuchtung 760 und einer Schattenmaske 770 (bspw. aus Metall) beleuchtet. Das epitaktisch erzeugte n-Si wird dabei ohne Beleuchtung nicht porös geätzt, da keine Defektelektronen vorhanden sind. Durch die mittels der Maske 770 erzeugte lokale Beleuchtung werden die notwendigen Ladungsträger im n-dotierten Bereich erzeugt, so dass an diesen Stellen 780 die n-dotierte Epitaxieschicht lokal porös geätzt werden kann. Erreicht der Ätzvorgang das darunter liegende p-dotierte Substrat 750, erfolgt eine ganzflächige Unterätzung. Mittels dieser Unterätzung kann das Substrat 750 im Bereich 765 porös geätzt werden, da im p-dotierten Bereich keine Beleuchtung notwendig ist. Neben einer Schattenmaske 770 können selbstverständlich auch Beugungsmuster und/oder holographische Gitter, wie in Figur 7b und c dargestellt, verwendet werden, um eine lokale Beleuchtung auf der Oberfläche der Epitaxieschicht 755 zu erzeugen.

Eine weitere Möglichkeit, ein Gitter auf porösem Silizium zu erzeugen besteht in der Verwendung einer strukturierten n-dotierten Si-Epitaxischicht. Zur Erzeugung dieser strukturierten n-dotierten Si-Epitaxischicht 805 wird, wie in Figur 9a gezeigt, auf ein p-dotiertes Si-Substrat 800 eine n-dotierte Si-Epitaxieschicht 805 aufgebracht, die in diesem Stadium noch unstrukturiert ist. Anschließend wird eine Oxidmaske 810 aufgebracht, die beispielsweise durch HF strukturiert werden kann. In einem weiteren Prozessschritt kann dann die n-dotierte Si-Epitaxieschicht 805 mittels Trenchgräben 815 über die im Oxid 805 erzeugte Trenchmaske strukturiert werden. Da der Trenchprozess nicht auf dem p-Si Substrat 800 stoppt, muss die Erzeugung der Trenchgräben 815 zeitgesteuert erfolgen. Ein leichtes Überätzen ins Substrat 800 ist jedoch unkritisch. Die so erhaltene Struktur aus Oxid 810, n-dotierter Epitaxie 805 und p-dotiertem Substrat 800 wird anschließend durch Anodisierung in HF porös geätzt, wie in Figur 9b dargestellt. Das Oxid 810 und die n-dotierte Epitaxieschicht 805 werden dabei nicht angegriffen, wohingegen das p-dotierte Si-Substrat 800 porös geätzt wird. Vor der nachfolgenden epitaktischen Abscheidung der Membran wird das Oxid 810 entfernt, so dass die Membran auf den n-dotierten Gitterstegen aufwachsen kann.

In einem nicht beanspruchten Beispiel kann, wie in den Figuren 10a bis c dargestellt wird, ein Gitter auf porösem Silizium 845 hergestellt werden, indem eine n-dotierte Si-Epitaxischicht 840 selektiv auf eine strukturierte SiO₂- oder Si₃N₄-Maske 835 aufgewachsen wird. Dabei wirkt die SiO₂- oder Si₃N₄-Maske 835 derart passivierend, dass das einkristalline Silizium 840 nur auf dem freigelegten Si-Substrat 830, also zwischen den Oxid- bzw. Nitridbereichen 835 aufwachsen kann, wie es in Figur 10b dargestellt ist. Anschließend kann, wie bereits mehrfach beschrieben und in Figur 10c dargestellt, ein poröser Bereich 845 im Substrat 830 erzeugt werden, der in einem nachfolgenden Tempervorgang zu einer Kaverne umgebildet werden kann.

Ein weiteres nicht beanspruchtes Beispiel verwendet unterschiedliche Porösitäten im Gitter- und im Kavemenbereich. Durch eine derartige Anpassung der Porösitäten in den genannten Bereichen ist eine Optimierung der Umlagerung des porösen Siliziums in eine Kaverne bzw. des Wachstums der epitaktischen Silizium-Membran möglich. So kann vorgesehen sein, im Kavernenbereich eine höhere oder eine niedrigere Porösität als im Bereich der Löcher zu erzeugen. Neben einer scharfen Trennung der unterschiedlichen Porösitätsbereiche ist auch ein Porösitäts-Gradient denkbar.

In der Startphase der Epitaxie zur Bildung der Membran ist jedoch darauf zu achten, dass die Kavernenschicht eine ausreichend stabile Grundlage bildet, so dass eine zu hohe Porösität in der Kavernenschicht nachteilig wäre. Daneben wäre es wünschenswert, auch in den Löchern im Gitterbereich eine hohe Porösität zu erzeugen, da dadurch die Bildung der Löcher zu Beginn des Wachstums der Epitaxie schneller erfolgt. Durch eine entsprechende Wahl einer (hohen) Porösität im Gitterbereich kann somit verhindert werden, dass das Wachstum auf dem umgelagerten Silizium in den Gitterlöchern beginnt. Würde nämlich zumindest ein Teil des Epitaxiewachstum auf dem Silizium zwischen den Gitterstegen während der Umlagerung beginnen, so könnten dadurch Kristallfehler entstehen, die sich in der Membranschicht weiterpflanzen würden, bspw. als Stapelfehler.

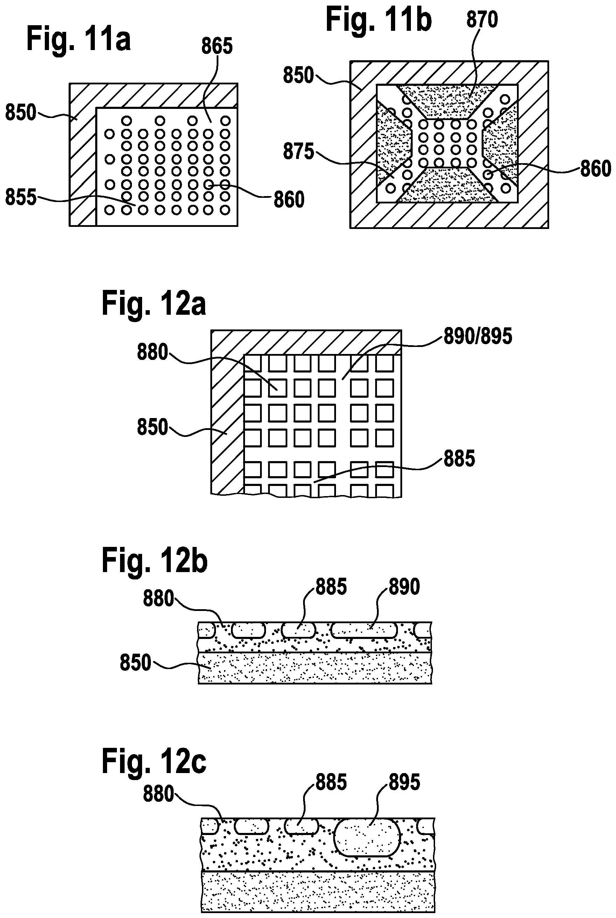

Zur Optimierung der mechanischen Eigenschaften der epitaktischen Si-Membran kann die Gitter- und die Lochgeometrie lokal variiert werden, wie es an den nicht beanspruchten Beispielen der Figuren 11a und 11b dargestellt ist. Durch eine derartige lokale Variation kann eine verbesserte Randeinspannung der Membran 855 an das Substrat 850 erreicht werden. Denkbar ist in diesem Fall das Weglassen von Gitterlöchern 860 in einem regelmäßigen Muster, beispielsweise am Membranrand, wie es in Figur 11a dargestellt wird. In diesem speziellen Beispiel wird auf jedes zweite Gitterloch am äußersten Rand der Lochgeometrie verzichtet, so dass beispielsweise an der Stelle 865 kein Gitterloch 860 zu finden ist. Daneben kann jedoch auch vorgesehen sein, dass die äußerste Lochreihe im Vergleich zu den weiter innen liegenden Löchern einen geringeren Durchmesser aufweisen. Ebenso ist denkbar, die Gitterstege am Rand der Membran zu verbreitern. Darüber hinaus ist jedoch auch möglich, das (Loch-)Gitter nur über einem Teil des Membrangebietes anzuordnen, so dass eine freistehende Membran entsteht, wie es in Figur 11b dargestellt ist. Dabei umschließt das Substrat 850 den Ätzbereich, der wiederum von Bereichen 875 mit Gitterlöchern 860 und Bereichen 870 ohne Gitterlöchern 860 abgedeckt wird. Auf den so strukturierten Bereichen 870 und 875 kann dann die Membran epitaktisch abgeschieden werden.

Die mechanischen Eigenschaften der Membran können ebenfalls durch entsprechend angepasste Geometrien der Gitterstege und Löcher variiert werden, so z.B. die Resonanzfrequenz und/oder die Steifigkeit. Eine Möglichkeit zur Erhöhung der Steifigkeit ist das Weglassen von Löchern in der Mitte der Membran. Ein sicheres Unterätzen der Löcher muss allerdings sichergestellt sein. Dies ergibt eine Grenze für die maximale Anzahl von Löchern, die weggelassen werden können.

Werden auf die Membran elektrisch aktive Elemente aufgebracht, kann es ebenfalls sinnvoll sein, lokal die Gitter- und Lochgeometrie anzupassen. Zum Beispiel können piezoresistive Widerstände, z.B. für einen Drucksensor, in einen Bereich gelegt werden, der durch eine besonders defektfreie Epitaxie ausgezeichnet ist (Vermeidung von Leckströmen und Nebenschlüssen durch sog. Diffusionpipes). Dies kann dadurch erreicht werden, dass in diesen Bereichen besonders wenige Gitterlöcher vorhanden sind, die epitaktisch überwachsen werden müssen und/oder eine besonders angepasste Gitter- und Lochgeometrie verwendet wird, die besonders gut überwachsen wird.

Selbstverständlich kann auch vorgesehen sein, mehrere verschiedene Gittergeometrien und - profile übereinander zu legen und sie so zu kombinieren. Das nicht beanspruchte Beispiel der Figur 12a zeigt die gleichzeitige Verwendung von zwei unterschiedlich rechteckigen Geometrien. Auf ein erstes monokristallines Gitter 885 mit schmalen Stegen, welches die porösen Bereiche 880 aufweist, wird ein zweites monokristallines Gitter 890 bzw. 895 mit breiteren bzw. dickeren Stegen überlagert. Eine derartige Kombination kann sowohl eine zusätzliche lokale Membranversteifung als auch eine verstärkte Einfassung der Membran im Substrat 850 ermöglichen.

Ein schematischer nicht maßstabsgetreuer Querschnitt durch einen Membranbereich mit unterschiedlichen Gittergeometrien ist im weiteren nicht beanspruchten Beispiel der Figur 12b dargestellt. Dabei ist deutlich zu erkennen, dass die Stege 885 und 890 unterschiedliche laterale Ausdehnungen aufweisen. Die Überlagerung verschiedener Geometrien zu einem Gitter kann darüber hinaus auch durch unterschiedliche Implantationen erreicht werden. Ebenso sind hierbei Variationen der Stegprofile des Gitters möglich, wie anhand des Querschnitts im weiteren Beispiel der Figur 12c gezeigt wird. In diesem Beispiel wurden zwei unterschiedliche Stege 885 und 895 durch unterschiedliche Implantationsenergien und damit unterschiedlicher Eindringtiefe erzeugt.

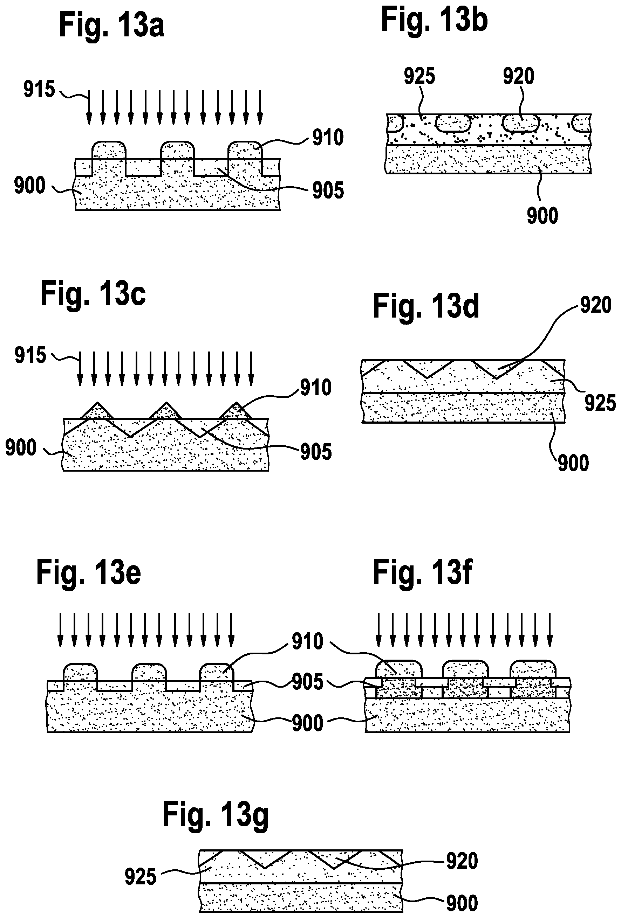

Neben der Anordnung der Löcher im Membranbereich können wie bereits erwähnt auch die Querschnittsprofile des Gitters auf die Anforderungen der zu erzeugenden Membranen abgestimmt werden, wie in den nicht beanspruchten Figuren 13a bis g gezeigt wird. Im einfachsten Fall werden, wie in den Figuren 13a und 13b dargestellt, Implantationsgebiete 905 (z.B. n-dotierte Bereiche in einem p-dotierten Substrat) zur Bildung eines Gitters 920 in das Substrat 900 eingebracht. Dabei werden zur gezielten Strukturierung der Implantationsgebiete 910 Masken 910 aus Fotolack oder Si-Oxid verwendet, die mittels eines Implantationsverfahren 915 bestrahlt werden. In diesem Implantationsverfahren kann die Energie bzw. die im Implantationsverfahren 915 verwendeten Teilchen auf das Substrat abgestimmt werden. Nachdem die Maske 910 entfernt ist, kann um die Implantationsgebiete 905 das Substrat 900 porösiziert werden, so dass Stege 920 im porösen Gebiet 925 entstehen.

Durch eine geeignete Wahl der Struktur der Maske 910 (z.B. einer Grautonmaske aus Fotolack oder Si-Oxid) in Verbindung mit einem entsprechenden Implantationsverfahren 915, kann das Gitterprofil in unterschiedlicher Art und Weise beeinflusst werden, wie es in Figur 13c und 13d gezeigt wird. Die in diesen Figuren dargestellte dreieckige Querschnittsform der Implantationsgebiete 905 hat Vorteile bezüglich der Umlagerung von porösem Silizium und der anschließenden Epitaxie. Durch den kleineren Lochdurchmesser an der Substratoberseite schließen sich die Löcher hier schneller. Darüber hinaus ist der Bereich, der durch die Epitaxie überwachsen werden muss kleiner. Dies führt zu weniger Kristallfehlem in der die Membran bildenden Epitaxieschicht.

Neben einer einfachen Implantation ist auch eine mehrfache Implantation mit unterschiedlichen Masken und/oder Implantationsenergien denkbar. Ein mögliches Resultat einer zweifachen Implantation mit einer Steigerung der Implantationsenergie im zweiten Implantationsschritt (Figur 13f) ist in den Figuren 13e bis g dargestellt. Dabei ergibt sich mit der Figur 13g ein ähnliches Gitterprofil wie bereits bei einer Maskierung des Substrats gemäß der Figur 13c.

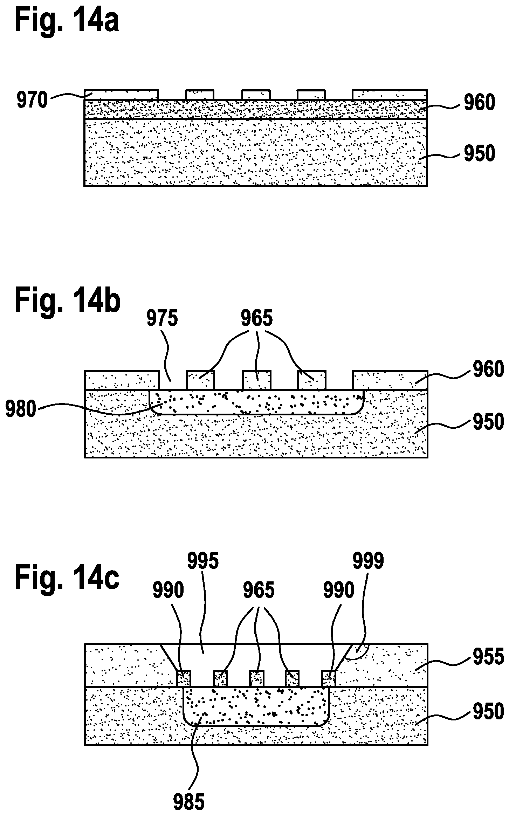

Allgemein können durch mehrfache Implantationen mit geeigneten Maskierungen und variierenden Implantationsenergien nahezu beliebige Gitterquerschnittsprofile erzeugt werden. Ein weiteres nicht beanspruchtes Beispiel zur Herstellung eines Gitters auf bzw. in einem porös geätzten Bereich ist in den Figuren 14a und 14b dargestellt. Dabei wird eine SiC-Schicht 960 mittels CVD (Silan &Propan) auf einem p-dotierten Si-Substrat 950 abgeschieden und mittels einer Oxidmaske 970 strukturiert, bspw. nass (in KOH, KClO₃, o.ä.) oder trocken (z.B. SF₆). Mittels der durch die Strukturierung der SiC-Schicht 965 entstandenen Löcher 975 zwischen dem Gitter 965 kann das p-dotierte Silizium durch eine Anodisierung selektiv zum SiC im Bereich 980 porös geätzt werden. Die Ursache dieser selektiven Ätzung besteht darin, dass SiC mit 2,4 eV (indirekt) bzw. 5,3 eV (direkt) eine deutlich höhere Bandlücke als Si aufweist. Nach der Herstellung des Gitters 965 aus SiC kann vorgesehen sein, die SiC-Schicht 960 bis auf das Gitter 965 und einen Rahmen 990, der das Gitter 965 einfasst, von der Oberfläche des Halbleiterträgers zu entfernen. Anschließend kann auf den Halbleiterträger 950 bzw. auf das Gitter 965 epitaktisch Silizium aufgebracht werden, um eine Membran zu bilden. Dabei wächst auf dem Rand des Halbleiterträgers 950 eine monokristalline Si-Schicht 955 und auf dem SiC 965 und 990 eine polykristalline Si-Schicht 995 auf. Der Übergang zwischen der monokristallinen Schicht 955 und der polykristallinen Schicht 995 wird durch die Epitaxieparametern bestimmt. So hängt der Winkel 999 maßgeblich von diesen Parametern ab. Der poröse Bereich kann vor oder nach dem Epitaxievorgang durch einen Temperschritt in einen Kavernenbereich umgewandelt werden.

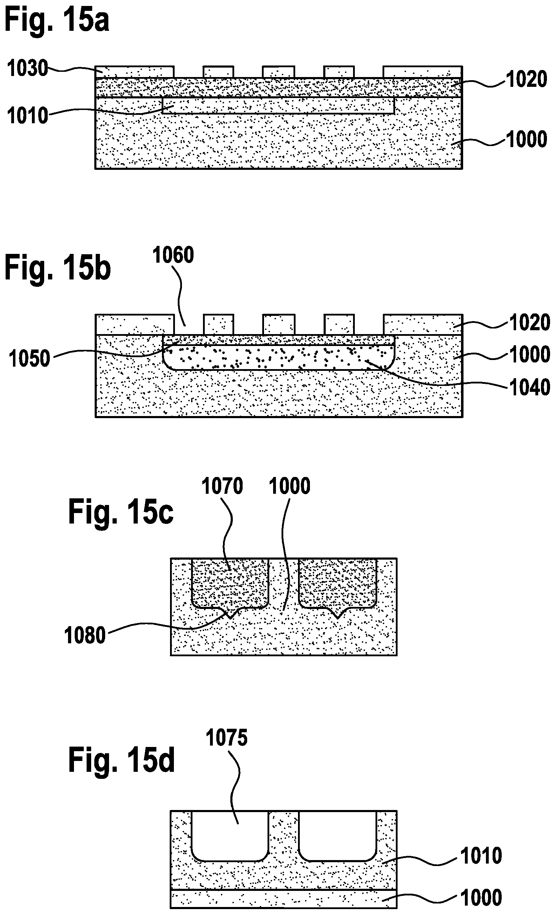

In einem weiteren Ausführungsbeispiel kann die Gitter- und Membranherstellung mit einer zusätzlichen p⁺-Dotierung erreicht werden. Diese zusätzliche p⁺-Dotierung kann beispielsweise das Verfahren, welches in der DE 101 38 759 A1 beschrieben wird, erweitern und optimieren. Wie in der Figur 15a dargestellt, wird auf einem p-dotierten Halbleitersubstrat 1000, beispielsweise einem Si-Substrat, eine Schicht 1010 mit einer zusätzlichen p⁺-Dotierung erzeugt, bevor der Halbleiterträger 1000 und die Schicht 1010 mit einer n-dotierten Epitaxieschicht 1020 abgedeckt wird. Mittels einer Oxidmaske 1030 kann anschließend die n-dotierte Epitaxieschicht 1020 strukturiert werden, beispielsweise durch einen Trenchprozess. Im Rahmen der Strukturierung ist vorgesehen, dass in der Epitaxieschicht 1020 Löcher bzw. Gräben 1060 entstehen, durch die ein Anodisierungsprozess zur Erzeugung einer (nano-) porösen p-dotierten Schicht 1040 im Halbleitersubstrat 1000 durchgeführt werden kann. Da die p⁺-dotierte Schicht 1010 weniger anfällig gegenüber diesem Anodisierungsprozess ist, entsteht in diesem Bereich eine im Vergleich zur Schicht 1040 geringer poröse Schicht 1050 mit Mesoporen, die über der Schicht mit Nanoporen liegt. Bei einer anschließenden Temperung lagert sich das Material in der nanoporösen Schicht 1040 in eine Kaverne um, wohingegen sich das Material in der mesoporösen Schicht 1050 zu einer geschlossenen Schicht umlagert. Die Bildung der geschlossenen Schicht unterstützt sowohl den Verschluss und das Überwachsen der Gitterlöcher 1060 während der nachfolgenden Epitaxie als auch die mechanische Stabilität des Gitters während der Temperung vor der Epitaxie.

Ein weiterer Vorteil der Verwendung einer zusätzlichen p⁺-Dotierung ergibt sich aus einer besseren Anpassung der Anodisierung bei der Gitterherstellung. Ohne die p⁺-Dotierung wird das p-dotierte Substrat unterhalb des Gitters 1070 in Form eines Schnabels 1080 unterätzt, wie es in Figur 15d dargestellt ist. Durch die zusätzliche p⁺-Dotierung 1010 kann dieser Schnabel vermindert bzw. verhindert werden, so dass sich eine wesentlich rundere Form an der Unterseite der Gitterstege 1075 ausbildet, wie in Figur 15d gezeigt wird.

Als besonders vorteilhaft hat sich erwiesen, wenn neben dem Halbleitersubstrat 1000 aus p-dotiertem Silizium auch die p⁺-dotierte Schicht 1010 und die n-dotierte Schicht 1020 aus Silizium besteht. Grundsätzlich ist jedoch auch die Verwendung von anderen Halbleitermaterialien denkbar.

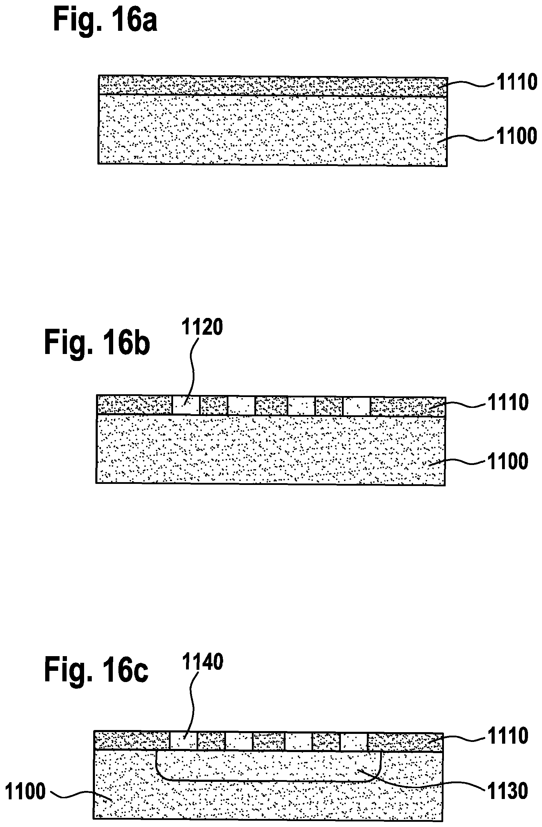

Weitere nicht beanspruchte Beispiele zur Herstellung eines Gitters und/oder einer Membran auf einem Halbleiterträger gemäß der Figuren 16a bis c betreffen die Erzeugung von p⁺-dotierten Bereichen in einer n-dotierten Schicht. Dabei wird zunächst auf einem p-dotierten Substrat 1100 eine flächige n-dotierte (monokristalline) Schicht 1110 aufgebracht. Denkbar ist hierbei, dass die n-dotierte Schicht 1110 mittels Implantation in das p-Substrat 1100 eingebracht oder mittels Belegung oder dünner Epitaxie aufgebracht wird. Anschließend werden in die n-dotierte Schicht 1100 p⁺-dotierte Bereiche 1120 eingebracht. Vorteilhafterweise erfolgt dieses Einbringen durch einen Implantationsvorgang, bei dem die p⁺-Dotierung ausreichend stark sein muss, um die n-dotierte Schicht 1110 lokal umzudotieren. Neben einem Implantationsvorgang können jedoch auch

andere Verfahren verwendet werden, die innerhalb der n-dotierten Schicht 1110 p⁺-dotierte Bereiche 1120 erzeugen.

Die so hergestellte und in Figur 16b dargestellte Struktur kann anschließend anodisiert werden, wobei die n-dotierte Schicht 1110 nicht angegriffen wird und monokristallin auf dem Substrat 1100 verbleibt. Die lokale p⁺-Dotierung 1140 wird dagegen porös geätzt. Wird die Anodisierung ausreichend lange durchgeführt, wird wie in Figur 16c dargestellt neben den p⁺-dotierten Bereichen 1040 auch der Bereich 1130 porös geätzt, der sich im p-Substrat 1100 unterhalb des p⁺-dotierten Bereichs 1040 befindet. Man erhält somit durch die n-dotierten Bereiche oberhalb des porös geätzten Bereichs 1130 Gitterstege aus n-dotiertem Material, zwischen denen sich porös geätztes p⁺-dotiertes Material befindet.

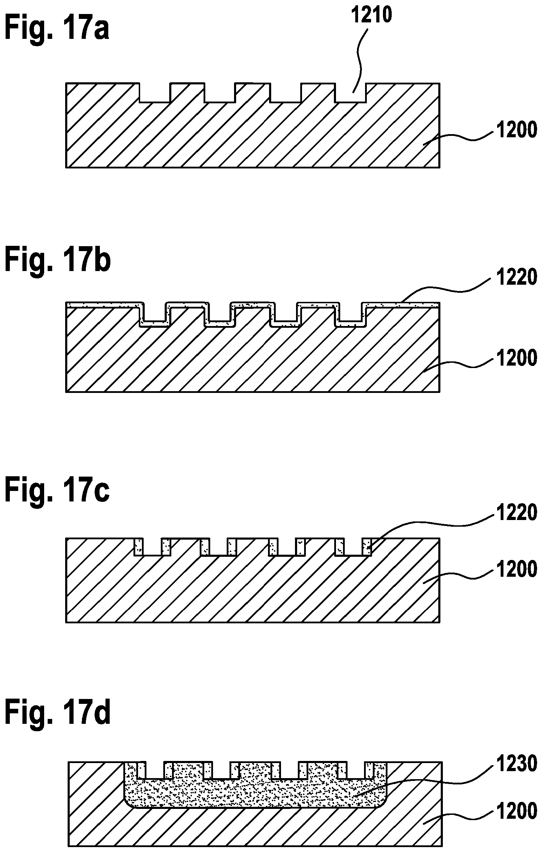

In einem weiteren Ausführungsbeispiel (Figur 17a bis d) zur Herstellung eines monokristallinen Gitters auf porösem Halbleitermaterial kann zunächst ein p-dotiertes Substrat 1200 mittels einer ersten Strukturierung strukturiert werden. Dabei definiert diese erste Strukturierung im wesentlichen den späteren Membranbereich. Vorteilhafterweise wird die erste Strukturierung derart gewählt, dass sie die halbe Periode der späteren Gitterkonstanten, d.h. des Abstands der Löcher 1210 voneinander aufweist. Auf das so strukturierte p-dotierte Substrat 1200 wird eine n-dotierte Epitaxieschicht 1220 aufgebracht. Anschließend wird ein Teil der n-dotierten Schicht 1220 durch einen physikalischen Ätzschritt entfernt, so dass eine Verringerung der Gitterkonstanten erreicht wird, wie es beispielhaft in Figur 17c dargestellt ist. Bei einer entsprechend gewählten Dicke der Schicht 1220 kann somit eine Halbierung der Gitterkonstanten erreicht werden. Durch die Verringerung der Gitterkonstanten erhält man eine wesentlich feinere Struktur der Gitterstege bzw. der Löcher 1210 auf der Oberfläche des Substrats 1200, so dass die Löcher 1210 einfacher überwachsen werden können. Es folgt eine Anodisierung, die wiederum die n-Dotierung nicht angreift, jedoch die p-Dotierung des Substrats porös ätzt und schließlich einen Bereich 1230 bildet, der die n-dotierten Gitterstege unterätzt (Figur 17d). Wie bereits mehrfach erwähnt, wird als letzter Schritt zur Herstellung der Membran eine Temperung und/oder eine Epitaxie durchgeführt. Die Temperung lagert das poröse Halbleitermaterial im Bereich 1230 um und verschließt die Löcher zwischen den Gitterstegen. Mit der Epitaxie wird hingegen die eigentliche Membran gebildet.

Durch die spezielle Art und Weise in der das n-dotierte Gitter in diesem Ausführungsbeispiel hergestellt wird, können nur solche Geometrien verwendet werden, die nach dem physikalischen Ätzen zusammenhängende Gitterstege ausbilden, z.B. eine schachbrettartige Geometrie (Figur 5e) oder ein stabförmiges Gitter (Figur 5f).

Bevorzugt wird Silizium als Halbleitermaterial für die vorstehenden Herstellungsverfahren zur Erzeugung eines Gitters über einer porösen Schicht verwendet. Es soll jedoch festgestellt werden, dass statt Silizium auch andere Materialien bzw. Halbleitermaterialien in dem Herstellungsverfahren verwendet werden können, die porös ätzbar sind, beispielsweise durch ein elektrochemisches Verfahren.

## Patentansprüche

1. Verfahren zur Herstellung eines Drucksensors, wobei zur Herstellung wenigstens die Verfahrensschritte
- Erzeugen eines strukturierten Stabilisierungselements (210, 230, 310, 410) mit wenigstens zwei Öffnungen (225, 425) im Oberflächenbereich eines Halbleiterträgers (200, 300, 400, 520),
wobei
• eine zweite strukturierte Epitaxieschicht (755, 805, 960, 1020, 1110, 1220) auf dem Halbleiterträger aufgebracht wird, deren Strukturierung in Abhängigkeit einer Belichtung und eines Ätzvorgangs oder eines Trenchprozesses erzeugt wird, wobei durch die strukturierte zweite Epitaxieschicht in einem zweiten Bereich im Oberflächenbereich des Halbleiterträgers das Stabilisierungselement erzeugt wird und die Öffnungen den Zugang zu einem mit einer ersten Dotierung aufweisenden ersten Bereich (220, 420, 560) im Halbleiterträger erlauben, und
- selektives Herauslösen wenigstens eines Teils des mit der ersten Dotierung versehenen Halbleitermaterials über die Öffnungen zur Erzeugung eines porösen ersten Bereichs des Halbleiterträgers mittels Anodisierung oder Elektropolitur, und
- Erzeugen einer Membran (240, 340, 440, 590) über dem porösen ersten Bereich durch Aufbringen einer ersten monokristallinen Epitaxieschicht (140, 240, 340, 440, 590) auf das Stabilisierungselement, wobei die erste Epitaxieschicht ausgehend von wenigstens einem Teil des Stabilisierungselements die wenigstens zwei Öffnungen über dem porösen ersten Bereich in lateraler und/oder vertikaler Richtung verschließen und
- Erzeugen einer Kaverne (250, 350, 450, 580) unterhalb des Stabilisierungselements aus wenigstens einem Teil des porösen ersten Bereichs vorgesehen sind,
wobei das Stabilisierungselement wenigstens einen monokristallinen Steg (210, 310, 410, 550) oberhalb der Kaverne aufweist, und
wobei der Steg eine kleinere laterale Ausdehnung als die halbe Kavernentiefe aufweist.

2. Verfahren zur Herstellung eines Drucksensors nach Anspruch 1,
**dadurch gekennzeichnet, dass** der erste Bereich (220, 420, 560) vor dem Aufbringen der ersten monokristallinen Epitaxieschicht (140, 240, 340, 440, 590) passiviert wird, um ein Aufwachsen der ersten Epitaxieschicht auf dem ersten Bereich zu verhindern.

3. Verfahren zur Herstellung eines Drucksensors nach Anspruch 1, **dadurch gekennzeichnet, dass** die erste Epitaxieschicht
- das Stabilisierungselement weitestgehend abdeckt und/oder
- zusammen mit dem Stabilisierungselement die Membran bildet.

4. Verfahren zur Herstellung eines Drucksensors nach Anspruch 1, **dadurch gekennzeichnet, dass** die zweite Epitaxieschicht mittels einer Passivierungsschicht (810, 835, 970, 1030) strukturiert auf den Halbleiterträger, insbesondere auf den ersten Bereich, aufgebracht wird, wobei vorgesehen ist, dass die so strukturierte zweite Epitaxieschicht miteinander verbundene Stege über dem ersten Bereich erzeugt.

5. Verfahren zur Herstellung eines Drucksensors nach Anspruch 1, **dadurch gekennzeichnet, dass** das Stabilisierungselement wenigstens eine Einfassung (170, 230, 330, 430) am Rand der Kaverne aufweist.

6. Verfahren zur Herstellung eines Drucksensors nach Anspruch 1 oder 5, **dadurch gekennzeichnet, dass**
- das Stabilisierungselement oberhalb der Kaverne unterschiedlich vertikale Ausdehnungen aufweist und/oder
- die Einfassung im Vergleich zu dem wenigstens einen Steg eine größere vertikale Ausdehnung aufweist.

7. Verfahren zur Herstellung eines Drucksensors nach Anspruch 1, 5 oder 6, **dadurch gekennzeichnet, dass** die Steifigkeit der Membran durch
- die Positionierung der Öffnungen auf dem Stabilisierungselement und/oder
- der Gestaltung der Stege, insbesondere durch die Variation der lateralen und/oder vertikalen Ausdehnung der Stege eingestellt wird.

8. Verfahren zur Herstellung eines Drucksensors nach Anspruch 7, **dadurch gekennzeichnet, dass** die Öffnungen im Wesentlichen nur am Rand der Membran vorgesehen sind, um eine Erhöhung der Steifigkeit der Membran zu erreichen.

9. Verfahren zur Herstellung eines Drucksensors nach einem der Ansprüche 1, 5, 6, 7 oder 8, **dadurch gekennzeichnet, dass** der Querschnitt des wenigstens einen Stegs durch eine mittels der zweiten Epitaxieschicht realisierte Maske einen weitestgehend trapezförmigen Querschnitt aufweist.

10. Verfahren zur Herstellung eines Drucksensors nach Anspruch 1, **dadurch gekennzeichnet, dass** die zweite Epitaxieschicht eine zweite Dotierung aufweist, wobei insbesondere vorgesehen ist, dass die erste und die zweite Dotierung unterschiedliche Dotierungen aufweisen.

11. Verfahren nach Anspruch 10, **dadurch gekennzeichnet, dass**
- der erste Bereich eine p-Dotierung und
- der zweite Bereich, die Einfassung und/oder das Gitter oder der wenigstens eine Steg eine n-Dotierung aufweist.

12. Mikromechanischer Drucksensor hergestellt nach einem der Verfahren 1 bis 11, mit
- einer Membran bestehend aus der verschließenden ersten monokristallinen Epitaxieschicht und wenigstens einem strukturierten Stabilisierungselement auf dem Halbleiterträger und
- einer unterhalb der Membran befindlichen Kaverne, wobei die Membran monokristallin ausgebildet ist, und
- das Stabilisierungselement wenigstens einen monokristallinen (siehe A1) Steg (210, 310, 410, 550) oberhalb der Kaverne aufweist, und der Steg eine kleinere laterale Ausdehnung als die halbe Kavernentiefe aufweist.

13. Mikromechanischer Drucksensor nach Anspruch 12, **dadurch gekennzeichnet, dass** die Membran piezoresistive Widerstände aufweist.

14. Mikromechanischer Drucksensor nach Anspruch 12, **dadurch gekennzeichnet, dass** auf der Membran eine Schaltung integriert ist.

15. Mikromechanischer Drucksensor nach Anspruch 12, **dadurch gekennzeichnet, dass** wenigstens ein Teil des Stabilisierungselements
- trapezförmige Stege oder
- Stege mit unterschiedlicher vertikaler und/oder lateraler Ausdehnung aufweist.

## Claims

1. Method for fabricating a pressure sensor, wherein at least the following method steps are provided for fabrication:
- producing a patterned stabilizing element (210, 230, 310, 410) having at least two openings (225, 425) in the surface region of a semiconductor carrier (200, 300, 400, 520),
wherein
• a second patterned epitaxial layer (755, 805, 960, 1020, 1110, 1220) is applied on the semiconductor carrier, the patterning of said epitaxial layer being produced depending on an exposure and an etching process or a trench process, wherein the stabilizing element is produced by the patterned second epitaxial layer in a second region in the surface region of the semiconductor carrier and the openings allow access to a first region (220, 420, 560) in the semiconductor carrier, said first region having a first doping, and
- selectively stripping out at least one portion of the semiconductor material provided with the first doping via the openings in order to produce a porous first region of the semiconductor carrier by means of anodizing or electropolishing, and
- producing a membrane (240, 340, 440, 590) above the porous first region by applying a first monocrystalline epitaxial layer (140, 240, 340, 440, 590) to the stabilizing element,
wherein the first epitaxial layer, proceeding from at least one portion of the stabilizing element, closes off the at least two openings above the porous first region in a lateral and/or vertical direction, and
- producing a cavity (250, 350, 450, 580) below the stabilizing element from at least one portion of the porous first region,
wherein the stabilizing element has at least one monocrystalline web (210, 310, 410, 550) above the cavity, and
wherein the web has a lateral extent that is smaller than half the depth of the cavity.

2. Method for fabricating a pressure sensor according to Claim 1,
**characterized in that** the first region (220, 420, 560) is passivated before the process of applying the first monocrystalline epitaxial layer (140, 240, 340, 440, 590) in order to prevent the first epitaxial layer from growing on the first region.

3. Method for fabricating a pressure sensor according to Claim 1, **characterized in that** the first epitaxial layer
- covers the stabilizing element to the greatest possible extent and/or
- together with the stabilizing element forms the membrane.

4. Method for fabricating a pressure sensor according to Claim 1, **characterized in that** the second epitaxial layer is applied to the semiconductor carrier, in particular to the first region, in a manner patterned by means of a passivation layer (810, 835, 970, 1030), wherein provision is made for the second epitaxial layer patterned in this way to produce interconnected webs above the first region.

5. Method for fabricating a pressure sensor according to Claim 1, **characterized in that** the stabilizing element has at least one enclosure (170, 230, 330, 430) at the edge of the cavity.

6. Method for fabricating a pressure sensor according to Claim 1 or 5, **characterized in that**
- the stabilizing element has differing vertical extents above the cavity and/or
- the enclosure has a larger vertical extent in comparison with the at least one web.

7. Method for fabricating a pressure sensor according to Claim 1, 5 or 6, **characterized in that** the stiffness of the membrane is set by
- the positioning of the openings on the stabilizing element and/or
- the shaping of the webs, in particular by the variation of the lateral and/or vertical extent of the webs.

8. Method for fabricating a pressure sensor according to Claim 7, **characterized in that** the openings are provided substantially only at the edge of the membrane in order to achieve an increase in the stiffness of the membrane.

9. Method for fabricating a pressure sensor according to any of Claims 1, 5, 6, 7 or 8, **characterized in that** the cross section of the at least one web has a cross section that is trapezium-shaped to the greatest possible extent by virtue of a mask realised by means of the second epitaxial layer.

10. Method for fabricating a pressure sensor according to Claim 1, **characterized in that** the second epitaxial layer has a second doping, wherein provision is made, in particular, for the first and second dopings to have different dopings.

11. Method according to Claim 10, **characterized in that**
- the first region has a p-type doping and
- the second region, the enclosure and/or the lattice or the at least one web have/has an n-type doping.

12. Micromechanical pressure sensor fabricated according to any of Claims 1 to 11, comprising
- a membrane consisting of the closing-off first monocrystalline epitaxial layer and at least one patterned stabilizing element on the semiconductor carrier and
- a cavity situated below the membrane,
wherein
- the membrane is embodied in a monocrystalline fashion, and
- the stabilizing element has at least one monocrystalline (see Claim 1) web (210, 310, 410, 550) above the cavity, and
the web has a lateral extent that is smaller than half the depth of the cavity.

13. Micromechanical pressure sensor according to Claim 12, **characterized in that** the membrane has piezoresistive resistors.

14. Micromechanical pressure sensor according to Claim 12, **characterized in that** a circuit is integrated on the membrane.

15. Micromechanical pressure sensor according to Claim 12, **characterized in that** at least one portion of the stabilizing element has
- trapezium-shaped webs or
- webs having a different vertical and/or lateral extent.

## Revendications

1. Procédé de fabrication d'un capteur de pression, le procédé de fabrication comprenant au moins les étapes suivantes
- générer un élément de stabilisation structuré (210, 230, 310, 410) pourvu d'au moins deux ouvertures (225, 425) ménagées dans la zone de surface d'un support semi-conducteur (200, 300, 400, 520),
• une deuxième couche d'épitaxie structurée (755, 805, 960,1020,1110,1220) étant appliquée sur le support semi-conducteur, la structuration de ladite couche étant générée en fonction d'une exposition à la lumière et d'un processus de gravure ou d'un processus de creusage de tranchée, l'élément de stabilisation étant généré dans une deuxième région de la zone de surface du support semi-conducteur à travers la deuxième couche d'épitaxie structurée et les ouvertures permettant d'accéder à une première région (220, 420, 560) du support semi-conducteur qui est pourvue d'un premier dopage, et
- extraire sélectivement au moins une partie du matériau semi-conducteur pourvu du premier dopage par les ouvertures pour générer une première région poreuse du support semi-conducteur par anodisation ou électro-polissage, et
- générer une membrane (240, 340, 440, 590) par-dessus la première région poreuse par application d'une première couche d'épitaxie monocristalline (140, 240, 340, 440, 590) sur l'élément de stabilisation,
la première couche d'épitaxie fermant, à partir d'au moins une partie de l'élément de stabilisation, les au moins deux ouvertures par-dessus la première région poreuse dans la direction latérale et/ou verticale et
- générer une cavité (250, 350, 450, 580) sous l'élément de stabilisation à partir d'au moins une partie de la première zone poreuse,
l'élément de stabilisation comportant au moins une nervure monocristalline (210, 310, 410, 550) au-dessus de la cavité, et
la nervure comportant une extension latérale inférieure à la moitié de la profondeur de la cavité.

2. Procédé de fabrication d'un capteur de pression selon la revendication 1, **caractérisé en ce que** la première région (220, 420, 560) est passivée avant l'application de la première couche d'épitaxie monocristalline (140, 240, 340, 440, 590) pour empêcher la croissance de la première couche d'épitaxie sur la première région.

3. Procédé de fabrication d'un capteur de pression selon la revendication 1, **caractérisé en ce que** la première couche d'épitaxie
- recouvre largement l'élément de stabilisation et/ou
- forme la membrane conjointement avec l'élément de stabilisation.

4. Procédé de fabrication d'un capteur de pression selon la revendication 1, **caractérisé en ce que** la deuxième couche d'épitaxie est appliquée sur le support semi-conducteur, en particulier sur la première région, en étant structurée au moyen d'une couche de passivation (810, 835, 970, 1030), une deuxième couche d'épitaxie ainsi structurée étant prévue qui génère sur la première région des nervures reliées entre elles.

5. Procédé de fabrication d'un capteur de pression selon la revendication 1, **caractérisé en ce que** l'élément de stabilisation comporte au moins une bordure (170, 230, 330, 430) au bord de la cavité.

6. Procédé de fabrication d'un capteur de pression selon la revendication 1 ou 5, **caractérisé en ce que**
- l'élément de stabilisation comporte des extensions verticales différentes au-dessus de la cavité et/ou
- la bordure comporte une plus grande extension verticale par rapport à l'au moins une nervure.

7. Procédé de fabrication d'un capteur de pression selon la revendication 1, 5 ou 6, **caractérisé en ce que** la rigidité de la membrane est réglée par
- le positionnement des ouvertures sur l'élément de stabilisation et/ou
- la conception des nervures, notamment par la variation de l'extension latérale et/ou verticale des nervures.

8. Procédé de fabrication d'un capteur de pression selon la revendication 7, **caractérisé en ce que** les ouvertures ne sont prévues sensiblement qu'au bord de la membrane afin d'obtenir une augmentation de la rigidité de la membrane.

9. Procédé de fabrication d'un capteur de pression selon l'une des revendications 1, 5, 6, 7 et 8, **caractérisé en ce que** la section transversale de l'au moins une nervure est une section transversale quasiment trapézoïdale par le biais d'un masque réalisé au moyen de la deuxième couche d'épitaxie.

10. Procédé de fabrication d'un capteur de pression selon la revendication 1, **caractérisé en ce que** la deuxième couche d'épitaxie présente un deuxième dopage, le premier et le deuxième dopage étant notamment prévus pour être différents.

11. Procédé selon la revendication 10, **caractérisé en ce que**
- la première région présente un dopage p et
- la deuxième région, la bordure et/ou le réseau ou l'au moins une nervure présentent un dopage n.

12. Capteur de pression micromécanique fabriqué selon l'un des procédés 1 à 11, ledit capteur comprenant
- une membrane pourvue de la première couche d'épitaxie monocristalline de fermeture et d'au moins un élément de stabilisation structuré sur le support semi-conducteur et
- une cavité située sous la membrane,
- la membrane étant monocristalline, et
- l'élément de stabilisation comportant au moins une nervure monocristalline (voir A1) (210, 310, 410, 550) au-dessus de la cavité, et la nervure comportant une extension latérale inférieure à la moitié de la profondeur de la cavité.

13. Capteur de pression micromécanique selon la revendication 12, **caractérisé en ce que** la membrane comporte des résistances piézo-résistives.

14. Capteur de pression micromécanique selon la revendication 12, **caractérisé en ce qu'**un circuit est intégré sur la membrane.

15. Capteur de pression micromécanique selon la revendication 12, **caractérisé en ce qu'**au moins une partie de l'élément de stabilisation comporte
- des nervures trapézoïdales ou
- des nervures pourvues d'extensions verticales et/ou latérales différentes.
